# EUROPEAN PATENT APPLICATION

(11) **EP 2 237 308 A2**
(43) Date of publication of application: **06.10.2010**
(21) Application number: 10158677.4
(22) Date of filing: 31.03.2010
(51) Int. Cl.: H01L 21/00, B28D 5/00, H01L 31/18

(54) **Manufacturing Unit for Integrated Thin Film Solar Cells**

(30) Priority: 01.04.2009 JP 2009089463
(71) Applicant: Mitsuboshi Diamond Industrial Co., Ltd., Suita-city, Osaka 564-0044 (JP)
(72) Inventor: Soyama, Masanobu, Suita-city Osaka 564-0044 (JP)
(74) Representative: TBK-Patent

(57) **Abstract**

The object of the present invention is to provide a manufacturing unit for solar cells with which high quality integrated thin film solar cells with a constant trench width can be manufactured at a high yield.

The means used for achieving the object of the present invention are a support for supporting a thin film solar cell substrate (W), a scribing head (7) for holding a tool for creating a trench (8) via a means for applying pressure, and a moving means for moving the substrate W and the scribing head (7) relative to each other are provided, and the means for applying pressure is formed of a voice coil motor (30) where the amount of current flowing into the motor can be controlled by a control portion S.

## Description

### [Technical Field]

The present invention relates to a manufacturing unit for chalcopyrite compound-based integrated thin film solar cells. Here, chalcopyrite compounds include CIGSS (Cu(In, Ga)(Se, S)₂), and CIS (CuInS₂) in addition to CIGS (Cu(In, Ga)Se₂).

### [Background Art]

Thin film solar cells using a chalcopyrite compound semiconductor as a light absorbing layer generally have an integrated structure where a number of unit cells are connected in series on a substrate.

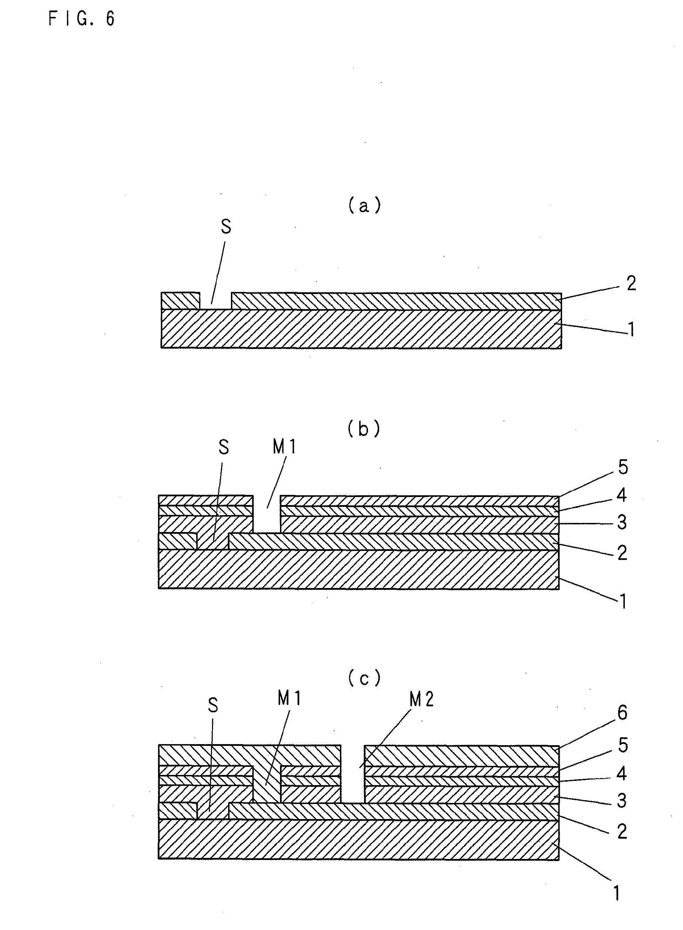

A conventional manufacturing method for chalcopyrite compound-based integrated thin film solar cells is described below. Figs 6(a) to 6(c) are schematic diagrams showing the manufacturing process for CIGS thin film solar cells. First, as shown in Fig 6(a), an Mo electrode layer 2 that becomes a lower electrode on the plus side is formed on an insulating substrate 1 made of soda lime glass (SLG) in accordance with a sputtering method, and after that, a trench S for separating lower electrodes is created in the thin film solar cell substrate through a scribing process before the formation of the light absorbing layer.

After that, as shown in Fig 6(b), a light absorbing layer 3 made of a compound semiconductor (CIGS) thin film is formed on the Mo electrode layer 2 in accordance with a vapor deposition method or sputtering method, and on top of this a buffer layer 4 made of a ZnS thin film for a heterojunction is formed in accordance with a CBD method (chemical bath deposition method), and on top of this an insulating layer 5 made of a ZnO thin film is formed. In addition, a trench M1 for contact between electrodes that reaches the Mo electrode layer 2 is created in the thin film solar cell substrate at a location from the trench S for separating lower electrodes by a predetermined distance in the lateral direction through a scribing process before the formation of the transparent electrode layer.

Next, as shown in Fig 6(c), a transparent electrode layer 6 made of a ZnO: Al thin film is formed on top of the insulating layer 5 as an upper electrode, and thus, a solar cell substrate having functional layers which are required for generating power using photoelectric conversion is provided, and a trench M2 for separating electrodes that reaches the lower Mo electrode layer 2 is created through a scribing process.

In the above described process for manufacturing integrated thin film solar cells, a laser scribing method and a mechanical scribing method are used as the technology for creating trenches M1 and M2 for separating electrodes through scribing.

In accordance with the laser scribing method, as disclosed in Patent Document 1, for example, a substrate is irradiated with a laser beam that oscillates by exciting an Nd: YAG crystal by means of a continuously discharging lamp, such as an arc lamp, so that a trench for separating electrodes can be created. In the case where a trench is created in a thin film solar cell substrate in accordance with this method after the formation of a light absorbing layer, there is a risk that the photoelectric conversion properties of the light absorbing layer 3 may deteriorate due to the heat from the laser beam during scribing.

As disclosed in Patent Documents 2 and 3, for example, the mechanical scribing method refers to a technology for creating a trench for isolating electrodes by moving the blade edge of a tool for creating a trench, such as of a metal needle of which the end is tapered, while pressing it against a substrate by applying a predetermined pressure. At present, this mechanical scribing method is often used.

### [Prior Art Documents]

### [Patent Documents]

[Patent Document 1] Japanese Unexamined Patent Publication H11 (1999)-312815
[Patent Document 2] Japanese Unexamined Patent Publication 2002-94089
[Patent Document 3] Japanese Unexamined Patent Publication 2004-115356

### [Summary of the Invention]

### [Problem to be Solved by the Invention]

According to the prior art, when a trench for separating electrodes is created using a tool for creating a trench, a spring air servo motor or a linear motor is used in the mechanism for applying pressure which presses the tool for creating a trench against the surface of a substrate. However, the processed thin film solar cells are very thin and the trenches are very shallow, and therefore, the pressure for pressing the tool for creating a trench against the substrate is very low when a trench is created, and thus, a fine control for the pressing force is required when a trench is created. Even a minute fluctuation in the conditions during processing greatly affects the quality of the processed product, and in the case where the load for pressing the tool is too great, for example, thin films peel irregularly in the created trench, while in the case where the load is too small, the tool may ride over the scrap of the removed film so as to bounce, causing ruptures in the trench, and thus, the design quality (efficiency in photoelectric conversion) cannot be achieved or the uniformity in the quality (reproducibility) cannot be expected.
Therefore, it is necessary to adjust the load for pressing the blade edge in accordance with the properties of the thin film in order to make the degree of peeling of thin films constant. However, control is difficult in a low pressure region in a mechanism for controlling the pressing force using a spring air servo motor, and there is a disadvantage that control is unstable even when a high level control system is integrated. In addition, control mechanisms using a linear servo motor have such problems that a current flows in only one phase when used for microscopic strokes, such as for creating a trench, making it easy for heat to be generated, and no quick response can be gained when the thrust force changes, thus making it difficult to control the pressing force.

In addition, in the mechanical scribing method as disclosed in Patent Documents 2 and 3, the blade edge of the tool for creating a trench is in a tapered needle form, but strictly speaking, the portion pressed against thin film solar cells is an end that is cut approximately laterally so as to be flat to have a large contact area. When the end is cut horizontally, the area of contact with a thin film becomes large, and therefore, a trench can be created relatively stably. Meanwhile, thin films may be greatly peeled irregularly due to the friction through the large contact area in such a manner that even an unnecessary portion is removed, causing a problem such that the properties of the solar cells deteriorate and the yield lowers.

In addition, the blade edge of the above described tool for creating a trench is in a truncated cone form having a tapered surface. Accordingly, in the case where the blade edge is polished when the blade edge is worn or chipped, the diameter of the blade edge becomes large, and as a result, the width of the scribed trench becomes greater than before polishing. Therefore, the same blade edge cannot be used over a long period of time or cannot be used repeatedly after polishing, and thus, there is a problem that this is not economical.

Thus, an object of the present invention is to provide a manufacturing unit for integrated thin film solar cells according to which trenches for separating electrodes can be created in a chalcopyrite compound-based integrated thin film solar cell substrate (precursor before the formation of a transparent electrode, for example) and trenches for upper and lower electrode contacts can be created in the various functional layers, such as a light absorbing layer formed between the upper and lower electrodes so that the width of the trenches is constant, the yield is high, and the quality of the product is uniform in terms of the efficiency in photoelectric conversion.

### [Means for Solving Problem]

In order to solve the above described problems, the manufacturing unit for integrated thin film solar cells according to the present invention is provided with a support means for supporting a thin film solar cell substrate, a scribing head for holding a tool for creating a trench via a means for applying pressure, and a moving means for moving the substrate and the scribing head relative to each other, wherein the means for applying pressure is formed of a voice coil motor.

### [Effects of the Invention]

According to the present invention, a voice coil motor is used as the source of pressure for the tool for creating a trench, and the pressure for pressing the substrate of the tool for creating a trench can be easily controlled in a low pressure region by controlling the amount of current applied across the voice coil motor. In addition, the substrate can be processed through rapid and precise operation due to the properties of the voice coil motor having quick response. As a result, a highly linear and precise trench for separating electrodes with a constant width can be processed.

The tool for creating a trench is made up of a body in rod form and a blade edge region formed at an end of the body, where the blade edge region has a long rectangular bottom, a front surface and a rear surface that rise from the short sides of the bottom, and left and right sides which are a pair of parallel surfaces that rise from the long sides of the bottom perpendicularly so that the corner formed between either the front or rear surface and the bottom may be used as the edge.
As a result, in the case where the edge is worn, the bottom and the front or rear surface, if necessary, are polished so that the edge can be repaired. In particular, the left and right sides of the blade edge portion are parallel to each other, and therefore, the width of the blade does not change even when the bottom is polished. Therefore, the width of the scribed trench after polishing can be maintained the same as before polishing.
Furthermore, in the case where two blade edges are created in the front and rear corner portions of the tool for creating a trench, when one blade edge is worn or damaged, the other can be used as a new product by switching the direction in which the tool is attached.

### [Brief Description of the Drawings]

Fig 1 is a perspective diagram showing the manufacturing unit for integrated thin film solar cells according to one embodiment of the present invention;
Fig 2 is a side diagram showing a scribing head portion for holding a tool for creating a trench;
Fig 3 is a cross sectional diagram showing a voice coil motor as a means for applying pressure;
Fig 4 is a perspective diagram showing the above described tool for creating a trench as viewed from the bottom;
Fig 5 is a figure showing an enlargement of the bottom of the above described tool for creating a trench; and
Figs 6(a) to 6(c) are schematic diagrams showing a manufacturing process for general CIGS-based thin film solar cells.

### [Best Mode for Carrying Out the Invention]

In the following, the present invention is described in detail in reference to the drawings showing the embodiments.

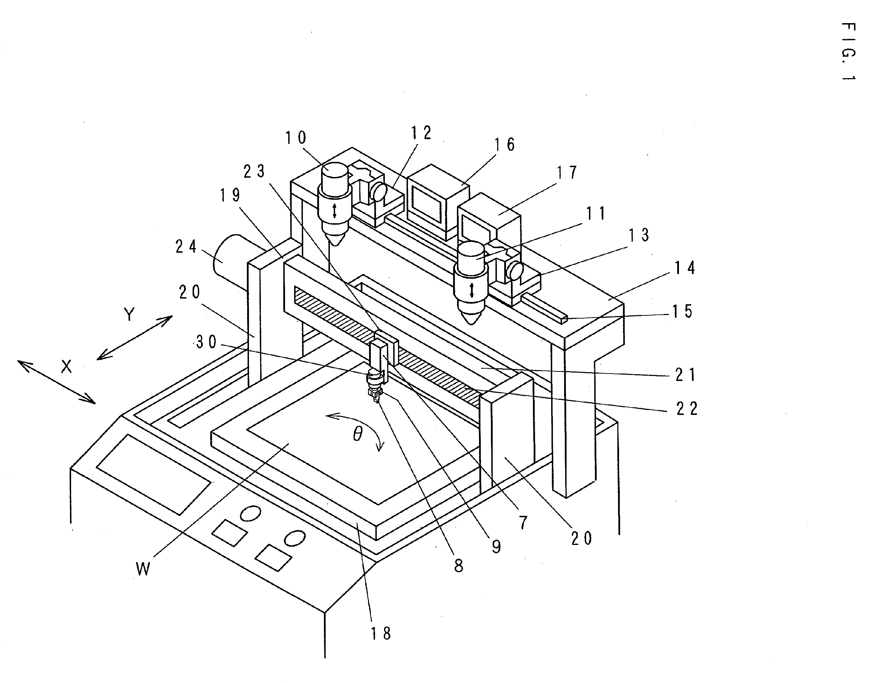

Fig 1 is a perspective diagram showing the manufacturing unit for integrated thin film solar cells according to one embodiment of the present invention. The unit is moveable in the lateral direction (Y direction) and has a table 18 that is rotatable by 90 degrees and an angle θ in a horizontal plane, and thus, the table 18 essentially forms a support means for a solar cell substrate W.

A bridge 19 formed of support poles 20, 20 on both sides, which are provided so as to sandwich the table 18, and a guide bar 21 extending in the X direction is provided so as to stretch over the table 18. A holder support 23 is attached so as to be moveable along a guide 22 formed on the guide bar 21 and moves in the X direction as a motor 24 rotates.

The holder support 23 is provided with a scribing head 7, and a tool for creating a trench 8, with which a scribing process is carried out on the surface of thin films of a solar cell substrate W mounted on the table 18, and a voice coil motor 30, which is a means for applying pressure which precedes this tool for creating a trench 8 against the solar cell substrate W, are attached to the scribing head 7.

In addition, cameras 10, 11 are respectively provided on pedestals 12, 13 which are moveable in the X direction and Y direction. The pedestals 12, 13 move along the guide 15 that extends in the X direction on the support 14. The cameras 10, 11 can be moved upwards and downwards by means of manual operation so that the focal point for taking an image can be adjusted. Images taken by the cameras 10, 11 are displayed on monitors 16, 17.

An alignment mark for specifying the location is provided on the surface of the solar cell substrate W mounted on the table 18, and the cameras 10, 11 take an image of the alignment mark so that the position of the solar cell substrate W can be adjusted. Concretely, an image of the alignment mark on the surface of the solar cell substrate W supported by the table 18 is taken by the cameras 10, 11 so that the location of the alignment mark is specified. A deviation in the direction of the surface of the solar cell substrate W when it is mounted is detected on the basis of the specified location of the alignment mark, and the table 18 is rotated by a predetermined angle so that the deviation is corrected.

Whenever the table 18 is moved by a predetermined pitch in the Y direction, the blade edge of the tool for creating a trench 8 is moved in the X direction in such a state that it is pressed against the surface of the solar cell substrate W by lowering the scribing head 7 so that a scribing process is carried out on the surface of the solar cell substrate W in the X direction. In the case where a scribing process is carried out on the surface of the solar cell substrate W in the Y direction, the table 18 is rotated by 90 degrees, and then, the same operation as in the above is carried out.

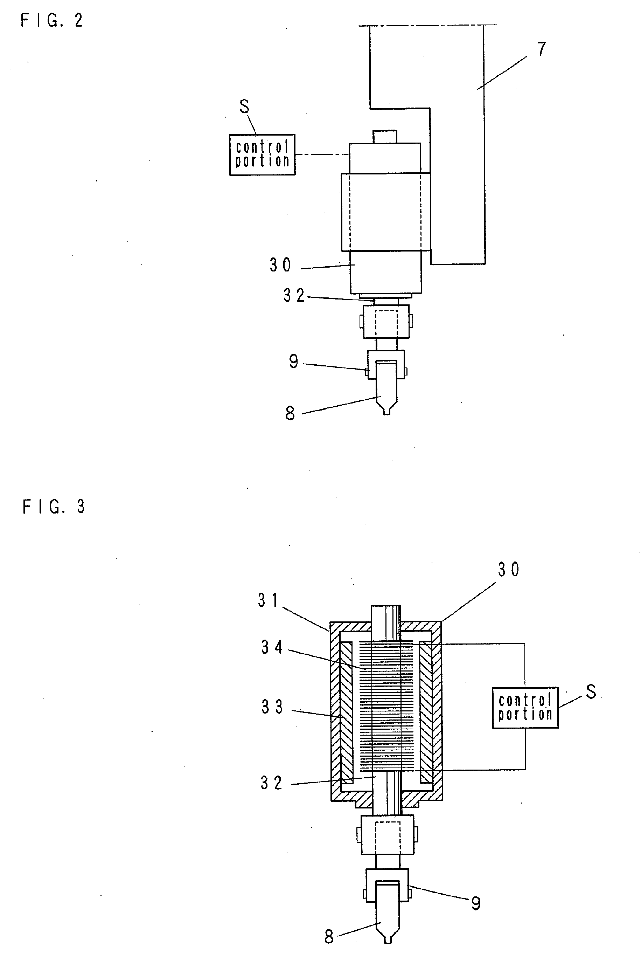

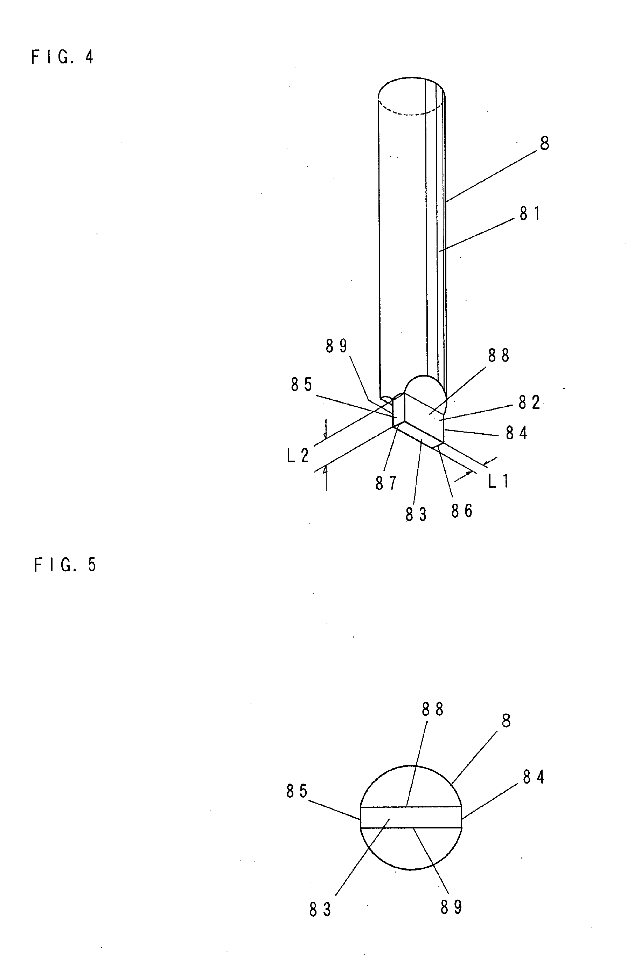

Figs 2 to 5 show a tool for creating a trench 8 and a voice coil motor 30 for pressing the tool for creating a trench against the solar cell substrate W. Fig 2 is a side diagram, Fig 3 is a schematic cross sectional diagram showing the voice coil motor, Fig 4 is a perspective diagram showing only the tool for creating a trench 8 as viewed from the bottom, and Fig 5 is a diagram showing an enlargement of the bottom of the tool for creating a trench.

The voice coil motor 30 is formed of a cylindrical case 31 fixed to the scribing head 7 and a moveable rod 32 provided to the axis portion of the fixed case 31 so as to be moveable upwards and downwards. A permanent magnet 33 for creating magnetic force is attached to the inner surface of the fixed case 31. A coil 34 for creating magnetic force, which interacts with the permanent magnet 33 and generates a downward thrust, is wound around the moveable rod 32. The coil 34 creates magnetic force when a current flows through from an external control portion S, and a downward thrust applied to the moveable rod 32, that is to say, pressing force, changes by adjusting the amount of current that flows. Here, a general purpose current control circuit with a microcomputer can be used for the control portion S.
Furthermore, a holder 9 for holding the tool for processing a trench 8 is provided at the lower end of the moveable rod 32.

The tool for creating a trench 8 is formed of a columnar body 81, which is essentially a portion attached to the holder 9, and a blade edge region 82 that is integral with the end portion of the body and formed through a discharge process and made of a hard material, such as a hard metal or diamond. The blade edge region 82 has a rectangular bottom 83, front surface 84 and a rear surface 85 that rise at a right angle from the short sides of the bottom 83, and the left and right sides 88 and 89 which rise at a right angle from the long sides of the bottom 83 and are parallel to each other. The corners formed between the bottom 83 and the front surface 84 and between the bottom 83 and the rear surface 85 respectively form blade edges 86, 87.

It is preferable for the width L1 of the bottom 83 to be 50 µm to 60 µm, and it can be 25 µm to 80 µm in accordance with the width of the trench for the required scribing. In addition, it is preferable for the effective height of the blade edge region 82, that is to say, the height L2 of the left and right sides 88, 89 as well as the front and rear surfaces 84, 85 of the blade edge region, to be approximately 0.5 mm. Furthermore, the diameter of the columnar body 81 may be approximately 2 mm to 3 mm. Here, the body 81 of the tool for creating a trench 8 is not limited to a columnar form, but it is possible for it to have such a form with a quadrilateral cross section or a polygonal cross section.

In the case where a process is carried out using the above described tool for creating a trench 8, the tool is attached to the holder 9 in such a state that the direction of the longitudinal axis of the bottom 83 of the blade edge region 82 is directed in the direction in which the tool moves and in such a state that the front surface 84 or the rear surface 85 of the blade edge region 82 inclines relative to the solar cell substrate W by a predetermined angle. It is preferable for the inclination angle in this case to be in a range from 50 degrees to 80 degrees, and it is more preferable for it to be in a range from 65 degrees to 75 degrees.

Next, a current with a predetermined value flows through the voice coil motor 30 via the control portion S, and thus, magnetic force is generated between the coil of the voice coil motor 30 and the permanent magnet so that the moveable rod 32 lowers. When the tool for creating a trench 8 makes contact with the surface of the substrate W, a pressure is applied to the substrate W, and therefore, the current value applied to the voice coil motor 30 changes. The tool for creating a trench 8 scribes at the location where the current value reaches a set value that is inputted into the control portion S in advance. In this case, the current value (pressure value) for the tool for creating a trench 8 to make contact with the substrate W precisely in a location where a trench is created may be detected prior to the start of the trench creating operation and inputted into the control portion S.

According to the present invention, the amount of current flowing through the voice coil motor 30 can be controlled so that the pressure at which the tool for creating a trench 8 is pressed against the substrate W can be simply and precisely controlled in a low pressure region, and in addition, delicate control is possible using the quick response properties of the voice coil motor 30, and thus, a linear trench for separating electrodes can be created.

In addition, the front surface 84 or the rear surface 85 of the tool for creating a trench 8 inclines towards the direction in which the tool progresses relative to the solar cell substrate W so that the corner portions formed between the front surface and the bottom as well as between the rear surface and the bottom, that is to say, the blade edge 86 or the blade edge 87, can smoothly peel the thin film when they make contact, which is line contact close to point contact, with the solar cell substrate W. In particular, the peeling of the thin film is smooth when the tool for creating a trench 8 inclines in the direction in which the tool progresses when the angle between the front surface 84 or the rear surface 85 of the blade edge region and the upper surface of the substrate W is within a range from 50 degrees to 80 degrees, especially within a range from 65 degrees to 75 degrees.

In addition, the two blade edges 86, 87 of the tool for creating a trench 8 are formed in the front and rear corner portions, and therefore, when one blade edge is worn or damaged, the other can be used as a new product by switching the direction in which the tool for creating a trench 8 is attached. In addition, in the case where both blade edges are worn, the blade edges can be repaired by polishing the bottom 83 in addition to the front and rear surfaces 84, 85 if necessary.

Here, though in the above described embodiments a scribing process is carried out by moving the scribing head 7 in the X direction, the scribing process is possible as long as the scribing head 7 and the solar cell substrate W move relative to each other, and therefore, the scribing head 7 may move in the X direction and Y direction in such a state that the solar cell substrate W is fixed, or only the solar cell substrate W may move in the X direction and Y direction without the scribing head 7 being moved.

Though the preferred embodiments of the present invention are described in the above, the present invention is not necessarily limited to the structures in the above described embodiments. Though it is preferable for the angle of the blade edge formed between the bottom and the front or rear surface to be approximately a right angle as described in the above embodiments, it is not greatly affected even when the angle is slightly obtuse, for example. In addition, appropriate modifications and changes are possible in the present invention as long as an object of the invention is achieved and the scope of the claims is not deviated from.

### [Industrial Applicability]

The present invention can be applied to manufacturing units for integrated thin film solar cells using a chalcopyrite compound-based semiconductor film.

### [Explanation of Symbols]

- W: solar cell substrate
- S: control portion
- 7: scribing head
- 8: tool for creating trench
- 30: voice coil motor
- 81: body
- 82: blade edge region
- 83: bottom of blade edge region
- 84: front surface of blade edge region
- 85: rear surface of blade edge region
- 86: blade edge
- 87: blade edge
- 88: side of blade edge region
- 89: side of blade edge region
[Object] To provide a manufacturing unit for solar cells with which high quality integrated thin film solar cells with a constant trench width can be manufactured at a high yield.
[Means for Achieving Object] A support for supporting a thin film solar cell substrate W, a scribing head 7 for holding a tool for creating a trench 8 via a means for applying pressure, and a moving means for moving the substrate W and the scribing head 7 relative to each other are provided, and the means for applying pressure is formed of a voice coil motor 30 where the amount of current flowing into the motor can be controlled by a control portion S.

## Claims

1. A manufacturing unit for integrated thin film solar cells, comprising:
a support means for supporting a thing film solar cell substrate;
a scribing head for holding a tool for creating a trench via a means for applying pressure; and
a moving means for moving said substrate and said scribing head relative to each other, **characterized in that**
said means for applying pressure is formed of a voice coil motor.

2. The manufacturing unit for integrated thin film solar cells according to Claim 1, wherein
said tool for creating a trench is made up of a body in rod form and a blade edge region formed at an end of the body,
the blade edge region has a long rectangular bottom, front and rear surfaces which rise from the short sides of the bottom, and left and right sides which rise from the long sides of the bottom and form a pair of surfaces which are parallel to each other, and
at least the corner portion formed between either the front or rear surface and the bottom becomes a blade edge.

3. The manufacturing unit for integrated thin film solar cells according to Claim 2, wherein the angle of the blade edge formed between the bottom and the front or rear surface is a right angle in said tool for creating a trench.

4. The manufacturing unit for integrated thin film solar cells according to Claim 2, wherein said scribing head is held so that the front or rear surface of the tool for creating a trench inclines within a range from 50 degrees to 80 degrees relative to said substrate.
